# EUROPEAN PATENT SPECIFICATION

(11) **EP 1 330 872 B1**
(45) Date of publication and mention of the grant of the patent: **26.11.2008**
(21) Application number: 00976898.7
(22) Date of filing: 03.11.2000
(51) Int. Cl.: H03G 3/30

(54) **ADJUSTMENT OF TRANSMITTER BIAS CURRENT BASED ON TRANSMITTER GAIN**
VORSPANNUNGSEINSTELLUNG EINES DATENÜBERTRAGUNGS- UND EMPFANGSSYSTEMS ANHAND DER ÜBERTRAGUNGSVERSTÄRKUNG
REGLAGE D'UN COURANT DE POLARISATION D'EMETTEUR EN FONCTION D'UN GAIN

(43) Date of publication of application: 30.07.2003
(73) Proprietor: QUALCOMM INCORPORATED, San Diego, CA 92121-1714 (US)
(72) Inventor: WALKER, Brett, C., San Diego, CA 92131 (US); SAHOTA, Kamal, Gurkanwal, San Diego, CA 92103 (US)
(74) Representative: Walsh, Michael Joseph
(86) International application number: PCT/US2000/030349
(87) International publication number: WO 2002/037673

(56) References cited:
- GB-A- 2 323 987
- US-A- 5 101 173
- US-A- 5 373 251
- US-A- 5 426 641
- US-A- 5 625 322

## Description

### BACKGROUND OF THE INVENTION

### I. Field of the Invention

The present invention relates to communications circuits. More particularly, the present invention relates to novel and improved techniques for adjusting the bias currents of circuits in a transmitter based on the signal gain of the transmitter.

### II. Description of the Related Art

The design of a high performance transmitter is made challenging by various design considerations. First, high performance is required for many applications. High performance can be defined by the linearity of the active devices (e.g., amplifiers, mixers, etc.) and their noise performance. Second, for some applications such as cellular communications systems, low power consumption is an important design goal because of the portable nature of the cell phones or remote stations. Generally, high performance and low power consumption impose conflicting design constraints.

In addition to the above design goals, some transmitters are required to provide a wide range of adjustment in their transmit output power. One application that requires this wide power adjustment is a Code Division Multiple Access (CDMA) communications system. In the CDMA system, the signal from each user is spectrally spread over the entire (e.g., 1.2288 MHz) system bandwidth. Thus, the transmitted signal from each transmitting user acts as interference to those of other users in the system. To increase system capacity, the output power of each transmitting remote station is adjusted such that a required level of performance (e.g., a particular bit error rate) is maintained while minimizing interference to other users.

The transmitted signal from the remote station is affected by various transmission phenomenons, including path loss and fading. These phenomenons, in combination with the need to control the transmit power, can impose a difficult specification on the required transmit power control range. In fact, for the CDMA system, each remote station transmitter is required to be able to adjust its output power over a range of approximately 85 dB.

The linearity of the remote station transmitter is also specified for the CDMA system (i.e., indirectly by an adjacent channel power rejection ACPR specification). For most active circuits, linearity is determined, in part, by the amount of current used to bias the circuits. Greater linearity can generally be achieved by using greater amounts of bias current. Also, greater range of linearity is needed for larger signal levels, which again can be achieved by using greater amounts of bias current.

To achieve the required level of linearity at all (including high) output power levels, the active circuits in the transmit signal path can be biased with large amounts of current. For example, the active circuits can be biased with the amount of bias current that provides the required level of linearity at the maximum specified output power level. This would ensure that the required level of linearity is provided at all transmit power levels. However, this scheme consumes large amounts of bias current at all times, even during transmissions at lower output power levels, thus resulting in wasteful consumption of power.

US Patent No. 5,625,322 discloses a device for controlling the biasing of an amplifier.

Accordingly, techniques that adjust the bias currents of the circuits in the transmit signal path to provide the required linearity while conserving power are highly desirable.

### SUMMARY OF THE INVENTION

The present invention, as set out in the appended claims, provides techniques to adjust the bias currents of active circuits in a transmitter based on the signal gain(s) of preceding circuits elements in the transmit signal path. Generally, the bias current for a particular active circuit affects various performances including linearity, noise figure, frequency response, and others. The amount of bias current that provides the required level of performance is dependent on the input signal or power level provided to the active circuit or the input signal level of a circuit element coupled to the active circuit. The input signal level can be estimated from the gain control signal(s) used to control the variable gain element(s) located prior to the active circuit in the transmit signal path.

An embodiment of the invention provides a method for controlling a bias current of an active circuit in a transmitter. In accordance with the method, at least one gain control signal for at least one variable gain element in a transmit signal path is received, with each gain control signal being indicative of an amplitude of a signal to be operated on by the active circuit. The active circuit can be located in the transmit signal path or peripheral to the signal path. The bias current of the active circuit is adjusted in accordance with the received gain control signal(s). To ensure proper circuit performance (i.e., the desire frequency response characteristics), the bias current can be limited to within a range defined by an upper limit Iₘₐₓ and a lower limit Iₘᵢₙ, where Iₘᵢₙ can be set to a percentage (i.e., 10 to 50 percent) of Iₘₐₓ, Iₘₐₓ and Iₘᵢₙ can be generated by programmable current sources, and can also be compensated for temperature and power supply variations.

Another embodiment of the invention provides a transmitter that includes at least one variable gain element, at least one active circuit, a gain control circuit, and at least one bias control circuit. The active circuit(s) couples to the variable gain element(s). The gain control circuit couples to the variable gain element(s) and provides a gain control signal for each variable gain element. The bias control circuit(s) couples to the gain control circuit and selected ones of the active circuit(s) and provides a bias signal for each selected active circuit. The bias signal is generated in accordance with the gain control signal from the gain control circuit. Each variable gain element can be implemented as a variable gain amplifier (VGA), an attenuator, a multiplier, or other circuits. The bias control circuit can be implemented with a pair of "current steering" differential pairs and a pair of (programmable) current sources, one current source for each current steering differential pair. A bandgap reference circuit can be used to provide a reference current that is stable over temperature and power supply variations.

### BRIEF DESCRIPTION OF THE DRAWINGS

The features, nature, and advantages of the present invention will become more apparent from the detailed description set forth below when taken in conjunction with the drawings in which like reference characters identify correspondingly throughout and wherein:
FIG. 1 shows a simplified block diagram of an embodiment of a transmitter;
FIG. 2 shows a diagram of a CDMA spread spectrum signal and distortion components generated by non-linearity in the transmit signal path;
FIG. 3 shows a plot of the signal swing of a circuit in the transmit signal path for a particular bias current setting;
FIG. 4 shows plots of the bias current I_{bias} and the signal current I_{signal} for a particular active circuit in the transmit signal path versus the input power level Pᵢₙ into the circuit;
FIG. 5 shows plots of the IF and RF VGA gains and the overall transmitter gain versus IF and RF gain controls for a specific transmitter embodiment;
FIG. 6 shows a plot of the input power level of a particular active circuit in the transmit signal path versus gain control;
FIG. 7 shows plots of the minimum bias current I_{bias,min} and the nominal bias current I_{bias,nom} for a particular active circuit in the transmit signal path versus gain control values; and
FIG. 8 shows a schematic diagram of an embodiment of a bias control circuit used to generate a bias current I_{bias} having a transfer function resembling the hyperbolic function shown in FIG. 7.

### DETAILED DESCRIPTION OF THE SPECIFIC EMBODIMENTS

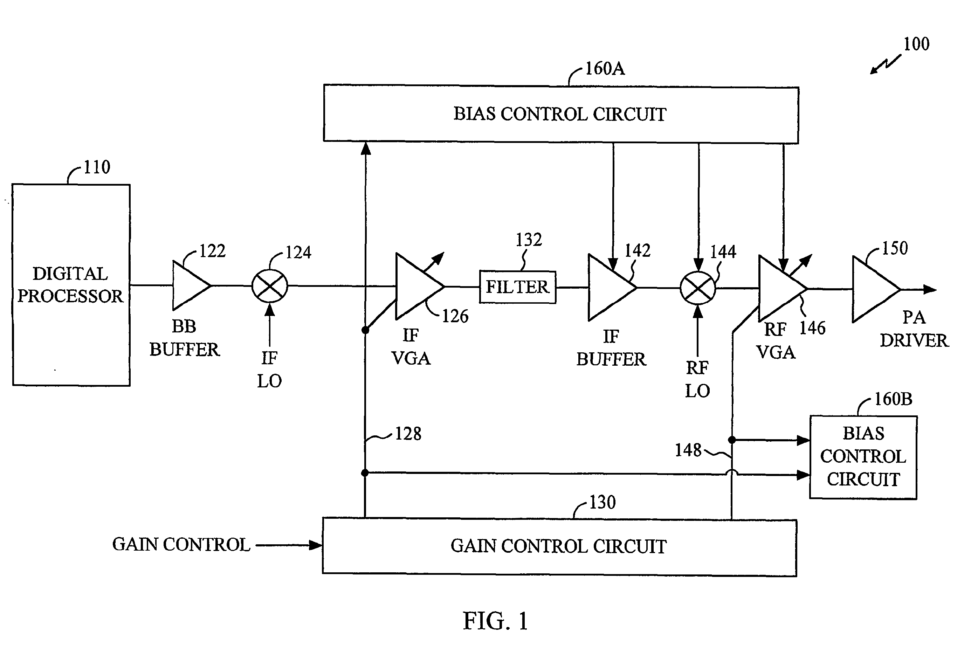

FIG. 1 shows a simplified block diagram of an embodiment of a transmitter 100. A digital processor 110 generates data, encodes and modulates the data, and converts the digitally processed data into an analog signal. The analog signal is provided to a baseband (BB) buffer 122 that buffers the signal and provides the buffered signal to a mixer 124. Mixer 124 also receives a carrier signal (e.g., a sinusoid) at an intermediate frequency (IF LO) and upconverts or modulates the buffered baseband signal with the IF LO to generate an IF signal. The IF signal is provided to an IF variable gain amplifier (IF VGA) 126 that amplifies the signal with a gain determined by a gain control signal 128 from a gain control circuit 130. The amplified IF signal is provided to a filter 132 that filters the IF signal to remove out-of-band noise and undesired signals. Filter 132 is typically a bandpass filter.

The filtered IF signal is provided to an IF buffer 142 that buffers the signal and provides the buffered IF signal to a mixer 144. Mixer 144 also receives another carrier signal (e.g., a sinusoid) at a radio frequency (RF LO) and upconverts the buffered IF signal with the RF LO to generate a RF signal. Mixer 124 and 144 can each be a single sideband mixer or a double sideband mixer. For a single sideband mixer, one or more phase shifters may be used to generate carrier signals having the proper phases. The RF signal is provided to a RF VGA 146 that amplifies the signal with a gain determined by a gain control signal 148 from gain control circuit 130. The amplified RF signal is provided to a power amplifier (PA) driver 150 that interfaces with subsequent circuitry such as an external filter (i.e., for filtering of image and spurious signals) and a power amplifier (both elements not shown in FIG. 1). The PA provides the required signal drive, and its output couples to an antenna via an isolator and a duplexer (not shown in FIG. 1).

Various modifications can be made to the transmitter embodiment shown in FIG. 1. For example, fewer or additional filter, buffer, and amplifier stages can be provided in the transmit signal path. Moreover, the elements within the signal path can be arranged in different configurations. In addition, the variable gain in the transmit signal path can be provided by VGAs (as shown in FIG.1), variable attenuators, multipliers, other variable gain elements, or a combination of the above. In a specific implementation, the transmit signal path from BB buffer 122 to PA driver 150 (possibly excluding filter 132) is implemented within one or more integrated circuits, although discrete elements can also be used.

In one specific transmitter embodiment, quadrature modulation is performed on an inphase (I) baseband signal and a quadrature (Q) baseband signal from the digital processor. In this design, a pair of BB buffers buffer the I and Q baseband signals and a pair of mixers modulate the buffered I and Q baseband signals with the inphase and quadrature IF LOs, respectively. The I and Q modulated signals are then combined to generate the IF signal. In another specific transmitter embodiment, quadrature modulation is performed digitally within the digital processor, and the modulated signal is then upconverted to IF or RF using one or more frequency upconversion stages.

Transmitter 100 can be used in many communication applications, such as cellular communication systems. Examples of cellular communication systems include Code Division Multiple Access (CDMA) communications systems, Time Division Multiple Access (TDMA) communications systems, and analog FM communications systems. CDMA systems are typically designed to conform to the "TIA/EIA/IS-95-A Mobile Station-Base Station Compatibility Standard for Dual-Mode Wideband Spread Spectrum Cellular System," hereinafter referred to as the IS-95-A standard. CDMA systems may further be designed to conform to the "TIA/EIA/IS-98 Recommended Minimum Standard for Dual-Mode Wideband Spread Spectrum Cellular Mobile Station," hereinafter referred to as the IS-98 standard.

The IS-95-A standard requires the output power from a remote station to be adjustable over a range of 85 dB in specified (e.g., 0.5 dB) increments. Typical remote stations are designed to transmit from between approximately - 50 dBm to +23 dBm. Typically, the circuits in the transmit signal path amplify or attenuate the signal so that a proper signal level is provided to the PA that interfaces with the antenna. In some transmitter embodiments, the output PA is designed with a fixed gain but variable drive capability. The variable drive can be provided by a PA design having multiple (i.e., parallel) drivers that can be selectively turned off when not required.

For some transmitter embodiments, and particularly for transmitter embodiments having fixed gain PAs, the required power control adjustment is provided by the VGAs in the transmit signal path. One VGA is typically not able to provide the entire (e.g., 85 dB) of gain adjustment and multiple cascaded VGAs are often used. The total required gain control range can be: 1) split between the IF VGA and the RF VGA, 2) provided entirely by the IF VGA, or 3) provided entirely by the RF VGA.

In some transmitter embodiments, one VGA is designed with fine gain adjustment (e.g., in increments of 0.5 dB) and the remaining VGA(s) are designed with coarse gain adjustment (e.g., in increments of several dBs or more). The coarse gain adjustment VGA can have two or more gain settings (e.g., low, intermediate, and high gains), with each gain setting corresponding to a particular range of transmitter output power levels. In some other transmitter embodiments, the VGAs can be designed to have variable (i.e., continuous) gain adjustment. The gains of the VGAs are typically controlled in a manner to provide high performance (i.e., improved linearity and reduced noise). Each VGA is typically controlled by its own gain control signal, although it is possible to control multiple VGAs with a common gain control signal.

The VGAs are designed to provide the required gain adjustment. The VGAs and other active circuits in the transmit signal path are also designed to provide the required level of linearity. The linearity of most active circuits is determined, in part, by the amount of current used to bias the circuits. Greater linearity can generally be achieved by using greater amounts of bias current. Also, greater range of linearity is needed for larger signal levels, which again can be achieved by using greater amounts of bias current.

The transmit signal path is typically designed to provide the required level of performance (i.e., linearity) at the worst case (i.e., maximum) output power level. The required level of performance can be achieved by biasing the circuits in the transmit signal path with high bias current. However, for some transmitters such as those in CDMA remote stations, the maximum transmission condition occurs only some of the time. Thus, in accordance with the invention, the bias currents of the circuits in the transmit signal path are reduced when not required (i.e., when transmitting at less than the maximum output power level).

As shown in FIG. 1, a bias control circuit 160a receives gain control signal 128 and can adjust the bias currents of IF buffer 142, mixer 144, and RF VGA 146 based on the received gain control signal. Similarly, a bias control circuit 160b receives gain control signals 128 and 148 and can adjust the bias current of PA driver 150 based on the received gain control signals. The adjustment of the bias currents based on the gain control signals is described below.

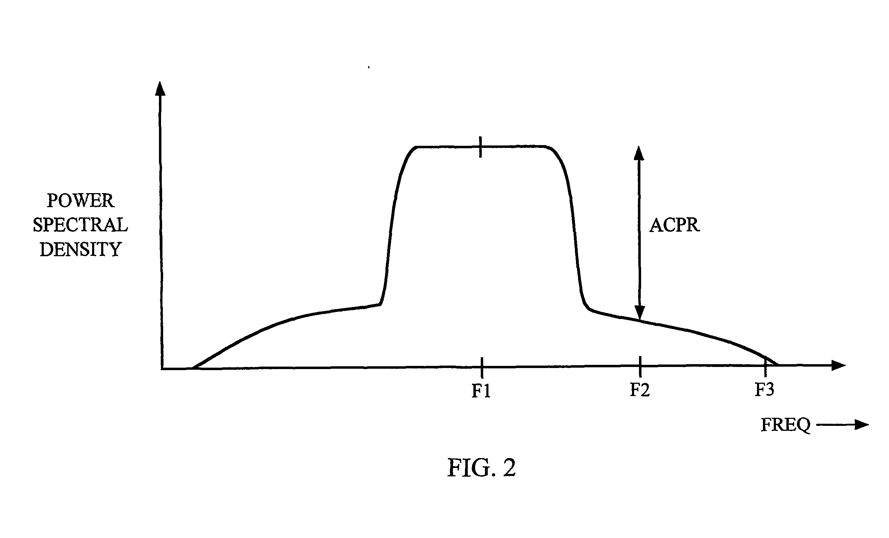

FIG. 2 shows a diagram of a CDMA spread spectrum signal and distortion components generated by non-linearity in the transmit signal path. The CDMA signal has a particular (e.g., 1.2288 MHz) bandwidth and a center frequency that is dependent on the operating mode (e.g., cellular or PCS). The distortion components are generated from the CDMA signal itself due to third and higher order non-linearity in the circuits in the transmit signal path. The distortion components, which are also referred to as spectral regrowth, cover the frequency band of the CDMA signal and the adjacent frequency bands. The distortion components act as interference on the CDMA signal and on the signals in the adjacent bands.

For third order non-linearity, signal components at frequencies of wₐ and w_{b} produce intermodulation products at frequencies of (2wₐ-w_{b}) and (2w_{b}-wₐ). Thus, in-band signal components can produce intermodulation products that can fall in-band or near band. These products can cause degradation in the CDMA signal itself and the signals in the adjacent bands. To compound the problem, the amplitude of the third-order intermodulation products is scaled by gₐ•g_{b}² and gₐ²•g_{b}, where gₐ and g_{b} are the gains of the signal components at wₐ and w_{b}, respectively. Thus, every doubling of the amplitude of the CDMA signal produces an eight-fold increase in the amplitude of the third order products.

For CDMA systems, the linearity of the remote station transmitter is specified by the adjacent channel power rejection (ACPR) specifications in the IS-95-A and IS-98 standards. The ACPR specifications typically apply to the entire transmit signal path, including the PA. The ACPR specifications are typically "apportioned" to different sections of the transmit signal path, each of which is then designed to meet the apportioned specifications. For example, the section of the transmit signal path shown in FIG. 1 (up to and including PA driver 150) may be required to maintain the distortion components at -36 dBc per 30 KHz bandwidth at 885 KHz offset from the CDMA center frequency, and -48 dBc per 30 KHz bandwidth at 1.98 MHz offset.

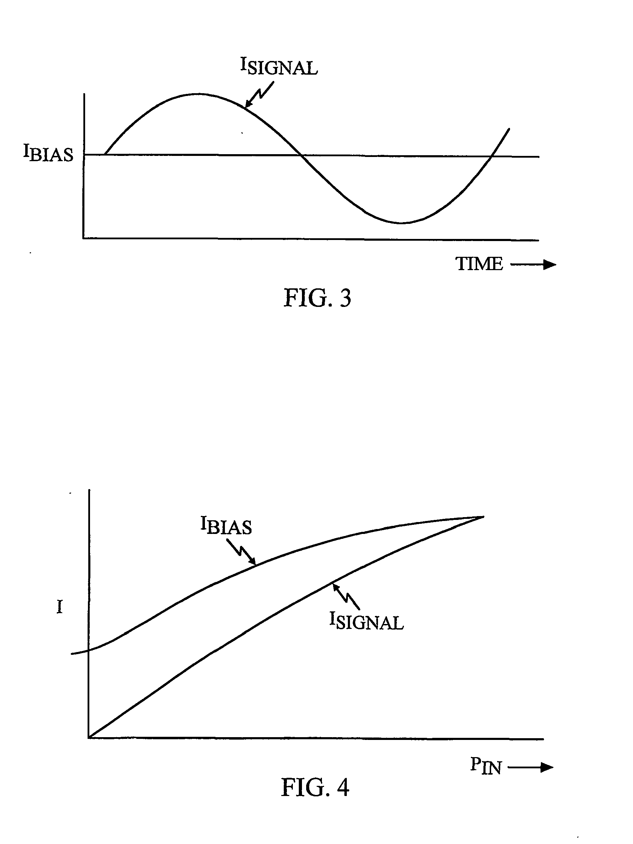

FIG. 3 shows a plot of the signal swing of a circuit in the transmit signal path for a particular bias current setting. As can be seen, the required bias current is dependent on the signal swing and should be set at least half the peak-to-peak signal swing. The linearity of the circuit typically degrades as the signal deviates further from the bias point, with the actual amount of non-linearity being dependent on the particular circuit design. Thus, the linearity of the output signal (e.g., the amount of spectral regrowth) is dependent on both the bias current and the signal swing

Generally, the amount of bias current required for a particular active circuit is dependent on the power (or signal) level of the input signal into the circuit. For a specific input power level Pᵢₙ, simulation can be performed or empirical measurements can be made to determine the minimum bias currents for the circuits in the transmit signal path that satisfy the ACPR specification and other performance criteria (e.g., noise figure and bandwidth). For example, for the transmitter embodiment shown in FIG. 1, the minimum bias currents that result in compliance with the IS-95-A ACPR specification can be individually determined for the buffers, mixers, VGAs, PA driver, and PA when the transmitter is transmitting at the maximum output power level. The simulation or measurement can then be repeated for these circuits at other power levels.

FIG. 4 shows plots of the bias current (I_{bias}) and the signal current (I_{signal}) for a particular active circuit (e.g., PA driver 150 in FIG. 1) in the transmit signal path versus the input power level (Pᵢₙ) into the circuit. These plots can be generated from the data obtained above through simulation or empirical measurements. Generally, the signal current I_{signal} increases as the input power level Pᵢₙ increases, and decreases as the input power level decreases (approaching zero signal current at zero input power level). The relationship between the signal current and the input power level may not be linear, and is typically dependent on the particular circuit design, the technology used, the power supplies, temperature, and other factors.

As shown in FIG. 4, the bias current I_{bias} for the active circuit is typically set higher than the signal current I_{signal}, with the difference decreasing at higher input power levels and increasing at lower input power levels. At higher input power levels, a large amount of bias current is already used for the circuit and the amount of "over-bias" is reduced in order to conserve supply current. At lower input power levels, only a small amount of bias current is required by the circuit and the amount of over-bias is increased to ensure proper RF performance (e.g., bandwidth, noise performance) without expending an excessive amount of supply current.

FIG. 4 shows plots for one active circuit in the transmit signal path. A similar set of plots can be generated for each active circuit in the transmit signal path. The data from these plots is used to adjust the bias currents of the active circuits, as described below.

As noted above, the bias current of each active circuit in the transmit signal path can be adjusted based on its input power level Pᵢₙ, or more specifically the power level at the input of the circuit. The input power level can be determined using various methods, some of which are described below.

In a specific transmitter design, a power detector is coupled to the transmit signal path, preferably after the variable gain elements. For example, the power detector can be placed after IG VGA 126 or after filter 132 in FIG. 1. The power detector detects the output power level from the circuit element and provides this information to the bias control circuit. The bias control circuit then adjusts the bias current of subsequent circuits in the transmit signal path based on the detected power level.

In accordance with an aspect of the invention, the input power level is estimated from the gain control signal(s) used to control the variable gain elements (e.g., IF VGA 126 and RF VGA 146) in the transmit signal path. For many transmitter designs, the gains of the VGAs are controlled in a manner to provide improved linearity and noise performance. Each transmitter output power level typically corresponds to a particular set of gain settings for the VGAs that achieve these performance objectives.

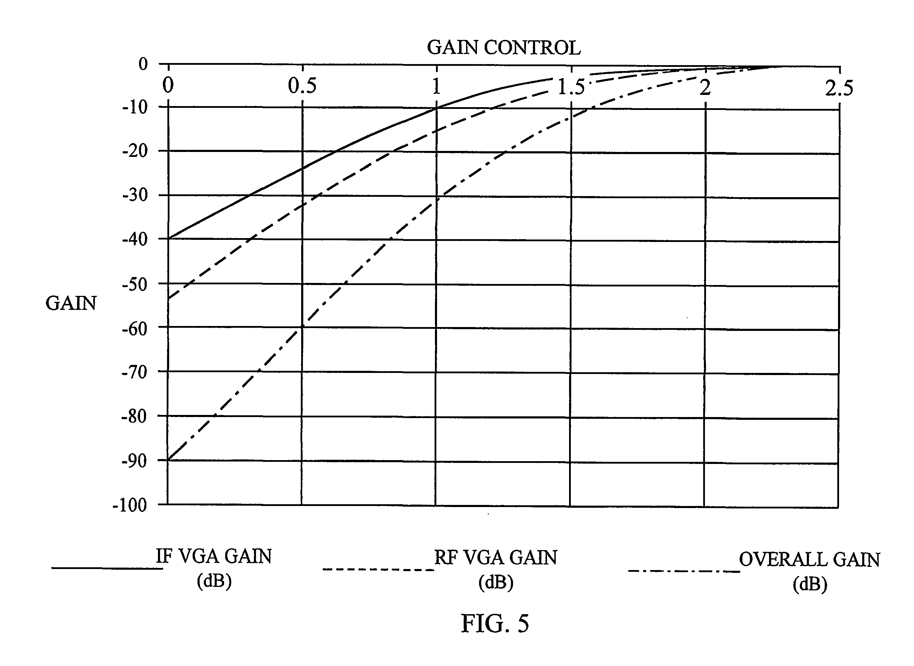

FIG. 5 shows plots of the IF and RF VGA gains and the overall transmitter gain versus the IF and RF gain controls for a specific transmitter embodiment. The transmitter includes two VGAs, one VGA at the IF frequency (e.g., IF VGA 126 in FIG. 1) having a gain range of approximately 38 dB and another VGA at the RF frequency (e.g., RF VGA 146 in FIG. 1) having a gain range of approximately 52 dB. The plots are each normalized such that the maximum gain is set to 0 dB. The overall gain of the transmit signal path is dependent on the gains of the two VGAs, and the overall gain range is a combination of the gain ranges of the two VGAs. The approximately 90 dB of overall gain range allows the transmitter to provide 85 dB of adjustment in the output power, as required by the IS-95-A standard.

For simplicity and as inferred from the plots shown in FIG. 5, the two VGAs are controlled by a common gain control signal or two gain control signals that approximately track together. At a particular gain control value (e.g., 1.0V), the overall gain is determined as the combination of the gains of the IF and RF VGAs at that control value (e.g., -10 dB + -17 dB = -27 dB). However, this simplification is not a required condition, and the VGAs can each be independently controlled by a separate gain control signal. For example, the gain of one VGA can be adjusted to a maximum gain before the gain of the other VGA is adjusted.

Because of the stringent power control setting mandated by the IS-95-A standard, the transmitter output power is sometimes calibrated at the factory. This calibration can be achieved by programming the gain control signals with known (i.e., digital) control values and measuring the output power from the transmitter. A table is then generated that maps each output power level to a set of (digital) control values. Thereafter, to set the transmit power at a particular power level, the table is accessed, the set of control values corresponding to the particular power level is retrieved, the retrieved control values are provided to the gain control circuit, the gain control signals are generated based on the control values, and the gains of the VGAs are adjusted with the gain control signals. For this transmitter implementation, the transmitter output power level and the input power levels at various locations along the transmit signal path can be accurately inferred from the gain control signals. However, even without the factory calibration, the input power levels can usually be estimated, to a sufficient degree of accuracy, from the gain control signals.

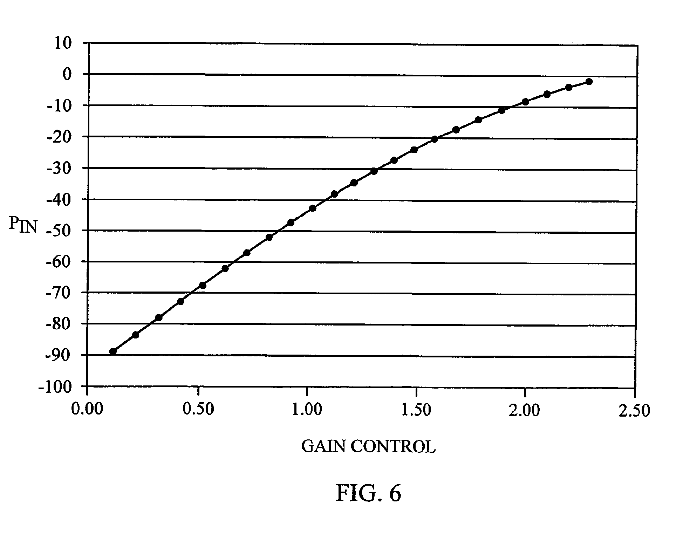

FIG. 6 shows a plot of the input power level of a particular active circuit (e.g., PA driver 150 in FIG. 1) in the transmit signal path versus gain control for a specific transmitter design. For this graph, the input power range is dependent on the gain ranges of the VGAs located prior to the circuit. Referring to FIG. 1, the input power level from each of IF buffer 142 and mixer 144 varies by an amount related to the gain range of IF VGA 126, or approximately 38 dB for the embodiment represented in FIG. 5. The input power level of PA driver 150 varies by an amount related to the gain ranges of IF VGA 126 and RF VGA 146, or approximately 90 dB. Thus, the plot of input power level versus gain control can be unique for each active circuit in the transmit signal path.

As shown in FIG. 6, the input power level of the active circuit is related to the signal gain(s) of the variable gain element(s) located prior to the active circuit in the transmit signal path. Using the simplification noted above in which VGAs 126 and 146 are adjusted with a common gain control signal or related gain control signals, the input power level of PA driver 150 can be plotted versus a single set of gain control values. At high gain control values, the VGA gains are high and the PA driver input power level is also high. Conversely, at low gain control values, the VGA gains are low and the input power level is also low.

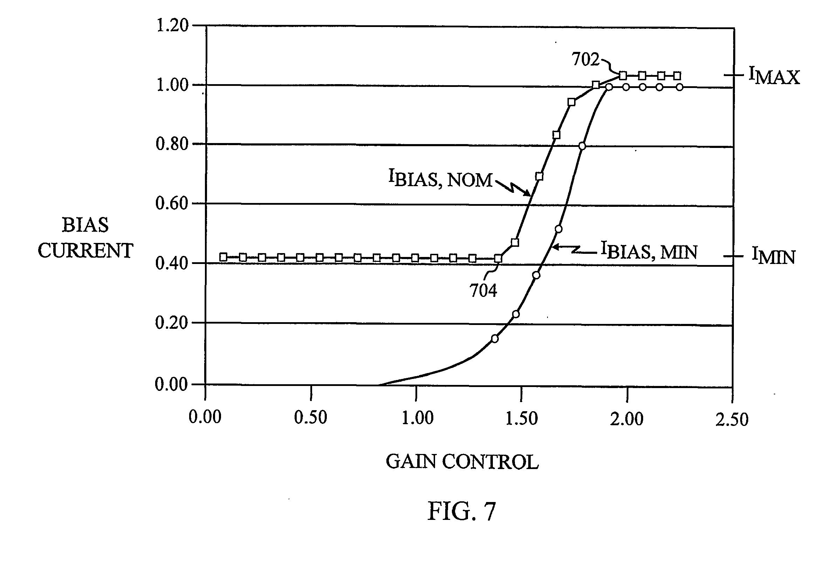

FIG. 7 shows a plot of the minimum bias current I_{bias,min} for a particular active circuit (e.g., IF buffer 142, mixer 144) in the transmit signal path versus gain control. This plot can be generated from the plot of the bias current I_{bias} versus input power level Pᵢₙ (see FIG. 4) and the plot of the input power level Pᵢₙ versus gain control (see FIG. 6). In FIG. 7, the minimum bias current I_{bias,min} is normalized such that the maximum bias amount is set to 1.0, which is also referred to as the full-scale value. At low input power levels, the required bias current approaches zero.

For many transmitter designs, it is impractical to operate the circuit at the minimum bias current I_{bias,min}. This may be due to a number of factors, such as variations in circuit performance (e.g., bandwidth and gain) over operation conditions (e.g., time, temperature, and supply voltages). Moreover, circuit performance typically varies from unit to unit due to component tolerance. Thus, to account for these factors, the actual or nominal bias current for the circuit is set higher than the minimum bias current.

FIG. 7 also shows a plot of the nominal bias current I_{bias,nom} for the circuit versus gain control. As shown in FIG. 7, the nominal bias current is set higher than the minimum bias current. The additional bias current, which is also referred to as the over-bias current, accounts for various factors such as error in the estimate of the actual input power level into the circuit, and so on. The additional bias current ensures that the circuit is sufficiently biased for correct operation and to provide the required level of linearity over operating conditions and component variations. The amount of additional bias current can be selected such that performance is maintained without excessively sacrificing potential current savings. In an embodiment, the amount of additional bias current is dependent on the input power level, with the amount of over bias being smaller (i.e., percentage wise) at greater bias current levels.

In the embodiment shown in FIG. 7, the nominal bias current I_{bias,nom} reaches an asymptotic upper value Iₘₐₓ above a point 702 and an asymptotic lower value Iₘᵢₙ below a point 704. In a specific embodiment, Iₘₐₓ is set approximately five percent higher than the full-scale value or a normalized value of approximately 1.05. The amount of over-bias is selected to be small at high input power levels because high bias current is already provided to the circuit. In a specific embodiment, Iₘᵢₙ is set at a particular percentage (e.g.,10 to 50 percent) of either the full-scale or Iₘₐₓ value. The bias current typically affects the frequency response and the bandwidth as well as the linearity of the circuit. Thus, limiting the bias current to Iₘᵢₙ or greater ensures that the circuit has the required performance (e.g., the required signal bandwidth) at all times.

The plot of the nominal bias current in FIG. 7 resembles a hyperbolic function between a maximum value Iₘₐₓ and a minimum value Iₘᵢₙ. In an embodiment, Iₘₐₓ and Iₘᵢₙ are programmable current values.

Referring to FIG. 1, filter 132 is typically implemented using a discrete filter. The insertion loss of the filter varies from one unit to another, and from one transmitter design to another. Consequently, some uncertainty exists as to the actual amplitude of the signal from the filter. As described above, in some transmitter implementations, the transmit signal path is characterized by empirical measurements performed at the factory, and the insertion loss of the filter is taken into account. However, even when no calibration is performed, the variation in the filter insertion loss is typically small and can be neglected. To provided additional safety margins, the bias currents of the circuits in the transmit signal path following the filter can be set slightly higher to account for the uncertainty in insertion loss.

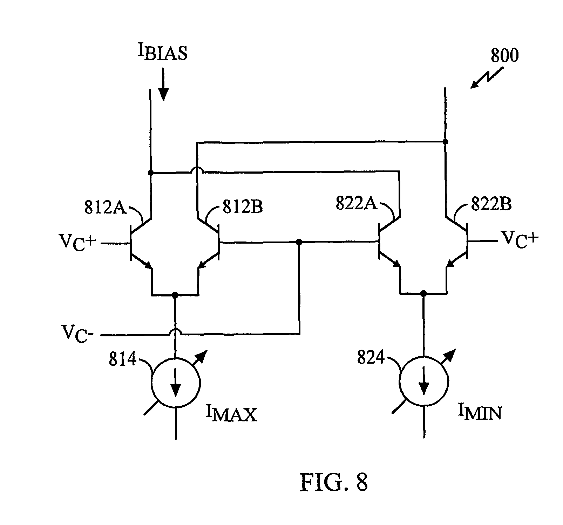

FIG. 8 shows a schematic diagram of an embodiment of a bias control circuit 800 used to generate a bias current I_{bias} having a transfer function resembling the hyperbolic function shown in FIG. 7. The bias current generated by bias control circuit 800 can be used for one circuit in the transmit signal path, such as IF VGA 126, IF buffer 142, mixer 144, RF VGA 146, or PA driver 150 in FIG.1.

Within bias circuit 800, a first differential pair comprising transistors 812a and 812b receives the differential gain control signals V_{c}+ and V_{c}-, respectively. The differential control signals V_{c}- and V_{c}+ can correspond to either gain control signal 128 or 148 in FIG. 1. The emitters of the first differential pair couple to a current source 814 that sets the maximum bias current Iₘₐₓ. A second differential pair comprising transistors 822a and 822b receives the differential gain control signals V_{c}- and V_{c}+, respectively. The emitters of the second differential pair couple to a current source 824 that sets the minimum bias current Iₘᵢₙ. The collectors of transistors 812a and 822a couple together to form the signal path for the bias current I_{bias}. Similarly, the collectors of transistors 812b and 822b couple together to form the signal path for the complementary bias current.

As shown in FIG. 8, current sources 814 and 824 can each be designed to be adjustable or programmable to allow for adjustment of Iₘₐₓ and Iₘᵢₙ. In a specific embodiment, each programmable current source is implemented with a bank of transistors that are selectively enabled based on a set of digital control values. The amount of current provided by the current source increases as more transistors in the bank are enabled. The current in the current source can be accurately set by using a current mirror, with the reference current in the current mirror being set by a bandgap reference circuit and an accurate (e.g., discrete, external) resistor. The use of the bandgap reference circuit and current mirror in this manner is known in the art and not described in detail herein.

In a specific embodiment, each programmable current source can be controlled by a digital-to-analog circuit (DAC). The DAC provides a control signal based on a set of digital control values. The control signal then determines the amount of current provided by the current source.

For a particular active circuit (e.g., PA driver 150 in FIG. 1) in the transmit signal path having a bias current that may be dependent on two or more gain control signals, the bias control circuit shown in FIG. 8 can be replicated for each control signal. The I_{bias} signal paths for all bias control circuits are coupled together, and the complementary I_{bias} signal paths of all bias control circuits are also coupled together. The Iₘₐₓ and Iₘᵢₙ currents corresponding to each gain control signal can be set based, for example, on the input power versus gain control transfer function determined above for the gain control signal.

FIG. 8 indicates that the bias current can be continuously adjusted in accordance with the gain control signal. In some transmitter embodiments in which one or more VGAs are adjusted in coarse increments, the bias currents of the circuits in the transmit signal path (including the PA driver) can be adjusted based on the coarse gain setting. At high input power levels, which generally correspond to high VGA gains, more bias current is needed for the larger signal swing. The transmitter recognizes the need for more bias current when the VGA gain is set to a high gain setting, and uses this information to increase the bias current of the circuit. This design conserves (battery) power by reducing bias current in the circuit when the input power level is low.

Referring back to FIG. 1, the gain of IF VGA 126 affects the power level at the inputs of subsequent circuits (after VGA 126) in the transmit signal path, including IF buffer 142, mixer 144, RF VGA 146, and PA driver 150. Thus, the bias currents of these circuits can be adjusted in accordance with gain control signal 128 that sets the gain of IF VGA 126. Similarly, the gains of VGAs 126 and 146 affect the power level at the inputs of subsequent circuits (after VGA 146) in the transmit signal path, including VGA 146 and PA driver 150. Thus, the bias current of these circuits can be adjusted in accordance with gain control signals 128 and 148. Generally, the bias current of any particular active circuit in the transmit signal path can be adjusted based on the gain control signal(s) of the variable gain elements preceding that circuit. This can be achieved since the bias control and gain control variations tend to track. One or more variable gain elements can be neglected in setting the bias current. For example, the bias current of PA driver 150 can be adjusted based solely on the gain of VGA 146, or solely on the gain of VGA 126, or the combined gain of both VGAs 126 and 146.

The bias control mechanism of the invention can also be used to adjust the bias currents of peripheral circuits in the transmitter, such as the buffers for the local oscillators (e.g., the buffers used to provide the IF LO and the RF LO in FIG.1). The bias current of a particular peripheral circuit can be adjusted based on the amplitude of the signal on which the circuit is designed to operate (albeit indirectly). The power level can be estimated from the gain control signal provided to the variable gain element(s) located "upstream" in the signal path. For example, the bias current of the buffer for the RF LO can be made dependent on gain control signal 128.

Table 1 tabulates the total bias current of the circuits in the transmit signal path for a specific transmitter embodiment. Other transmitter embodiments are also possible and are within the scope of the invention For this specific embodiment, in the sleep mode, the transmitter is turned off by shutting off the bias current to most circuits in the transmit signal path. In the idle mode, the circuits are bias in preparation for operation, but no transmissions occur. The cellular and PCS modes operate on two frequency bands, and may be characterized by the use of different LO frequencies and different PAs.

**Table 1**

| Mode | IF VGA Gain | RF VGA Gain | Total Transmitter Bias Current |
|---|---|---|---|
| Sleep | x | x | <1µA |
| Idle | x | x | 6mA |
| Cellular | Low | Low | 35 mA |
| | Low | High | 41 mA |
| | High | Low | 78 mA |
| | High | High | 91 mA |
| PCS | Low | Low | 34 mA |
| | Low | High | 42 mA |
| | High | Low | 74 mA |
| | High | High | 92 mA |

In FIG. 1, the (analog) gain control signals provided to the VGAs are also provided to the bias control circuits. In some transmitter embodiments, each gain control signal is generated by a DAC based on an input digital control value. The transmitter can also be designed such that the bias control circuits receive the digital control values, instead of the (analog) gain control signals, from the gain control circuit.

As shown in FIG.1, gain control circuit 130 and bias control circuits 160a and 160b are implemented as individual circuits. However, these circuits can also be implemented within a single circuit, or integrated within other circuits such as digital processor 110. The control circuits can also be integrated within the integrated circuit that implements the circuits in the transmit signal path.

The foregoing description of the preferred embodiments is provided to enable any person skilled in the art to make or use the present invention. Various modifications to these embodiments will be readily apparent to those skilled in the art, and the generic principles defined herein may be applied to other embodiments without the use of the inventive faculty. Thus, the present invention is not intended to be limited to the embodiments shown herein but is to be accorded the widest scope consistent with the principles and novel features disclosed herein.

## Claims

1. A method for controlling a bias current of an active circuit in a transmitter comprising a plurality of variable gain elements and a plurality of active circuits, the control of the bias current being based on one or more of the gain control signals for the variable gain elements preceding the active circuit in the transmit signal path, the method comprising:
receiving at a bias control circuit the gain control signals for the one or more variable gain elements located prior to the active circuit in the transmit signal path, wherein each gain control signal is indicative of an amplitude of an input signal to be operated on by the active circuit; and adjusting the bias current of the active circuit in accordance with the received gain control signals, **characterised in that** one or more of the received gain control signals may be neglected in the adjustment of the bias current.

2. The method of claim 1, wherein the active circuit is located in the transmit signal path.

3. The method of claim 1, wherein the adjusting is performed in increments defined by increments in value of the received gain control signals.

4. The method of claim 3, wherein one of the received gain control signals is adjusted in increments as defined by IS-95-A standard.

5. The method of claim 1, further comprising:
limiting the bias current to within a range defined by an upper bias current and a lower bias current.

6. The method of claim 5, wherein the lower bias current is set at between 0 to 50 percents of the upper bias current.

7. The method of claim 1, wherein the bias current versus the received gain control signals approximately conforms to a hyperbolic tangent transfer function.

8. The method of claim 1, wherein the bias current is adjusted to achieve a level of linearity that conforms to an adjacent channel power rejection ACPR specification defined by IS-95-A standard.

9. The method of claim 1, wherein the bias current is compensated for temperature and power supply variations.

10. The method of claim 1, wherein the bias current is adjusted based on gain control signals for all variable gain elements located in the transmit signal path prior to the active circuit.

11. The method of claim 1, further comprising:
characterizing an input power level of the active circuit versus gains of the one or more variable gain elements in the transmit signal path; and
generating a table of control values, the control values defining the gains of the one or more variable gain elements for specified input power levels, wherein the gain control signals are generated in accordance with the control values from the table.

12. The method of claim 1, wherein the active circuit is in a transmit signal path of a cellular transmitter, the bias current is adjusted to achieve a level of linearity that conforms to an adjacent channel power rejection ACPR specification defined by IS-95-A standard; and
the bias current is limited to within a range defined by an upper bias current and a lower bias current, the lower bias current being set to a percentage of the upper bias current.

13. A transmitter (100) comprising:
a plurality of variable gain elements (126, 146);
a plurality of active circuits (144;150) coupled to the plurality of variable gain elements (126; 146), each active circuit receiving a respective input signal having an amplitude determined by one or more variable gain elements located prior to the active circuit;
a gain control circuit (130) coupled to the plurality of variable gain elements (126; 146), the gain control circuit (130) configured to provide a gain control signal (128, 148) for each variable gain element (126; 148); anc at least one bias control circuit (160; 800) coupled to the gain control circuit (130) and to selected ones of the plurality of active circuits (144; 150), the bias control circuit (160) configured to provide a bias signal for each selected active circuit (144; 150), wherein the bias signal for a particular active circuit (144; 150) is generated in accordance with one or more gain control signals (128; 148) received at the bias control circuit for one or more variable gain elements (126, 146) located prior to the particular active circuit (150), **characterised in that** one or more of the received gain control signals may be neglected in the generation of the bias signal.

14. The transmitter (100) of claim 13, wherein each variable ga n element (126; 146) is implemented with a variable gain amplifier (VGA), an attenuator, or a multiplier.

15. The transmitter (100) of claim 13, wherein the plurality of active circuits includes a mixer (144).

16. The transmitter (100) of claim 13, wherein the plurality of active circuits includes a power amplifier (150).

17. The transmitter (100) of claim 13, wherein each bias control circuit (800) comprises:
a pair of current sources (814; 824), one current source configured to provide a first bias current and the other current source configured to provide a second bias current, wherein the bias signal provided by the bias control circuit (800) is limited to a value between the first and second bias currents.

18. The transmitter (100) of claim 17, wherein each bias control circuit (800) further comprises:
a pair of differential pairs (812; 822), one differential pair coupled to each current source (814; 824).

19. The transmitter (100) of claim 17, wherein the current sources (814; 824) are programmable.

20. The transmitter (100) of claim 13, further comprising:
a bandgap reference source coupled to the at least one bias control circuit (800).

21. The transmitter (100) of claim 13, wherein the plurality of variable gain elements (126; 146) and the plurality of active circuits (144; 150) are implemented within a monolithic integrated circuit.

22. The transmitter (100) of claim 13, wherein the plurality of variable gain elements (126; 146) and the plurality of active circuits (144; 15C) are implemented using discrete elements.

23. A cellular telephone comprising the transmitter (100) of Claim 13: wherein each bias control circuit (800) includes a pair of current sources (814; 824), one current source configured to provide a first bias current and the other current source configured to provide a second bias current, wherein the bias signal provided by the bias control circuit (800) is limited to a value between the first and second bias currents, and a pair of differential pairs (812; 822), one differential pair coupled to each current source (814; 824).

## Patentansprüche

1. Ein Verfahren zum Steuern eines Bias- bzw. Vorspannstroms einer aktiven Schaltung in einem Sender, wobei der Sender eine Vielzahl von Elementen mit variabler Verstärkung, eine Vielzahl von aktiven Schaltungen aufweist, wobei die Steuerung des Bias-Stroms basiert wird auf eines oder mehrere der Verstärkungssteuersignale für die Elemente mit variabler Verstärkung, die der aktiven Schaltung in dem Sendesignalpfad vorausgehen, wobei das Verfahren Folgendes aufweist:
Empfangen bei einer Bias-Steuerschaltung der Verstärkungssteuersignale für das eine oder die mehreren Elemente mit variabler Verstärkung, die angeordnet sind vor der aktiven Schaltung in dem Sendesignalpfad, wobei jedes Verstärkungssteuersignal anzeigend ist für eine Amplitude eines Eingabesignals, auf das es durch aktive Schaltung anzuwenden ist; und Anpassen des Bias-Stroms der aktiven Schaltung gemäß der empfangenen Verstärkungssteuersignale, **gekennzeichnet dadurch, dass** ein oder mehrere der empfangenen Verstärkungssteuersignale in der Anpassung des Bias-Stroms vernachlässigt werden kann.

2. Verfahren nach Anspruch 1, wobei die aktive Schaltung in dem Sendesignalpfad angeordnet ist.

3. Verfahren nach Anspruch 1, wobei die Anpassung ausgeführt wird in Inkrementen, definiert durch Inkremente im Wert der empfangenen Verstärkungssteuerungssignale.

4. Verfahren nach Anspruch 3, wobei eines der empfangenen Verstärkungssteuersignale angepasst ist in Inkrementen, wie definiert in dem IS-95-A Standard.

5. Verfahren nach Anspruch 1, das weiterhin Folgendes aufweist:
Begrenzen des Bias-Stroms auf einen Bereich, definiert durch einen oberen Bias-Strom und einen unteren bzw. niedrigeren Bias-Strom.

6. Verfahren nach Anspruch 5, wobei der untere Bias-Strom auf einen Wert zwischen 0 bis 50% des oberen Bias-Stroms gesetzt ist.

7. Verfahren nach Anspruch 1, wobei der Bias-Strom in Abhängigkeit von den empfangenen Verstärkungssteuerungssignalen annähernd im Einklang ist mit einer hyperbolischen Tangent-Transfer-Funktion.

8. Verfahren nach Anspruch 1, wobei der Bias-Strom angepasst wird, um ein Linearitätslevel zu erlangen, der im Einklang steht mit der ACPR-Spezifizierung (ACPR = adjacent channel power rejection bzw. Nebenkanal-Leistungszurückweisung), definiert in dem IS-95-A-Standard.

9. Verfahren nach Anspruch 1, wobei der Bias-Strom kompensiert wird hinsichtlich Temperatur- und Leistungsversorgungsschwankungen.

10. Verfahren nach Anspruch 1, wobei der Bias-Strom angepasst wird, basierend auf Verstärkungssteuerungssignalen für alle Elemente mit variabler Verstärkung, angeordnet in dem Sendesignalpfad vor der aktiven Schaltung.

11. Verfahren nach Anspruch 1, das weiterhin Folgendes aufweist:
Charakterisieren eines Eingangsleistungspegels der Aktivschaltung in Abhängigkeit von Verstärkungen der einen oder mehreren Elemente mit variabler Verstärkung in dem Sendesignalpfad; und
Generieren einer Tabelle von Steuerwerten, wobei die Steuerwerte die Verstärkung der einen oder mehreren variablen Verstärkungselemente für spezifizierte Eingangsleistungspegel definieren, wobei die Verstärkungssteuerungssignale generiert werden gemäß den Steuerwerten von der Tabelle.

12. Verfahren nach Anspruch 1, wobei die Aktivschaltung sich in einem Sendesignalpfad eines Zellsenders befindet, der Bias-Strom angepasst wird, um einen Linearitätslevel zu erlangen, der im Einklang steht mit der ACPR-Spezifizierung definiert in dem IS-95-A-Standard; und
der Bias-Strom beschränkt ist auf einen Bereich, definiert durch einen oberen Bias-Strom und einen unteren Bias-Strom, wobei der untere Bias-Strom gesetzt wird auf einen Prozentwert des oberen Bias-Stroms.

13. Ein Sender (100), der Folgendes aufweist:
eine Vielzahl von Elementen mit variabler Verstärkung (126, 146);
eine Vielzahl von aktiven Schaltungen (144, 150), gekoppelt an die Vielzahl von Elementen mit variabler Verstärkung (126; 146), wobei jede aktive Schaltung ein jeweiliges Eingabesignal empfängt mit einer Amplitude, bestimmt durch eines oder mehrere der Elemente mit variabler Verstärkung angeordnet vor der aktiven Schaltung;
eine Verstärkungssteuerungsschaltung (130), gekoppelt an die Vielzahl von Elementen mit variabler Verstärkung (126; 146), wobei die Verstärkungssteuerungsschaltung (130) konfiguriert ist zum Vorsehen eines Verstärkungssteuerungssignals (128, 148) für jedes Element mit variabler Verstärkung (126; 148); und
mindestens eine Bias-Steuerschaltung (160; 800), gekoppelt an die Verstärkungssteuerungsschaltung (130) und an ausgewählte Schaltungen der Vielzahl von aktiven Schaltungen (144; 150), wobei die Bias-Steuerungsschaltung (160) konfiguriert ist zum Vorsehen eines Bias-Signals für jede ausgewählte Schaltung (144; 154), wobei das Bias-Signal für eine bestimmte aktive Schaltung (144, 150) generiert wird gemäß einem oder mehrere Verstärkungssteuerungssignale (128; 148), empfangen an der Bias-Steuerschaltung für ein oder mehrere variable Verstärkungselemente (126, 146), angeordnet vor der bestimmten aktiven Schaltung (160), **gekennzeichnet dadurch, dass** eines oder mehrere der empfangenen Verstärkungssteuerungssignale vernachlässigt werden kann in der Generierung des Bias-Signals.

14. Sender (100) nach Anspruch 13, wobei jedes Element mit variabler Verstärkung (126, 146) implementiert ist als ein VGA bzw. Verstärker mit variabler Verstärkung, ein Dämpfungsglied, oder als ein Multiplizierer.

15. Sender (100) nach Anspruch 13, wobei die Vielzahl von aktiven Schaltungen ein Mischelement (144) beinhaltet.

16. Sender (100) nach Anspruch 13, wobei die Vielzahl von aktiven Schaltungen einen Leistungsverstärker (150) aufweist.

17. Sender (100) nach Anspruch 13, wobei jede Bias-Steuerschaltung (800) Folgendes aufweist:
ein Paar von Stromquellen (814; 824), eine Stromquelle, konfiguriert zum Vorsehen eines ersten Bias-Stroms und die andere Stromquelle, konfiguriert zum Vorsehen eines zweiten Bias-Stroms, wobei das Bias-Signal, vorgesehen durch die Bias-Steuerungsschaltung (800) begrenzt ist auf einen Wert zwischen dem ersten und zweiten Bias-Strom.

18. Sender (100) nach Anspruch 17, wobei jede Bias-Steuerungsschaltung (800) weiterhin Folgendes aufweist:
ein Paar von Differenzialpaaren (812, 822), wobei ein Differenzialpaar gekoppelt ist an jede Stromquelle (814; 824).

19. Sender (100) nach Anspruch 17, wobei die Stromquellen (814; 824) programmierbar sind.

20. Sender (100) nach Anspruch 13, der weiterhin Folgendes aufweist:
eine Bandlücken-Referenzquelle, gekoppelt an die mindestens eine Bias-Steuer- bzw. Steuerungsschaltung (800).

21. Sender (100) nach Anspruch 13, wobei die Vielzahl von Elementen mit variabler Verstärkung (126; 146) und die Vielzahl von aktiven Schaltungen (144, 150) implementiert sind als eine monolithische integrierte Schaltung.

22. Sender (100) nach Anspruch 13, wobei die Vielzahl von variablen Verstärkungselementen (126; 146) und eine Vielzahl von aktiven Schaltungen (144; 150) implementiert sind unter Verwendung von diskreten Elementen.

23. Ein Zell- bzw. Mobiltelefon, das den Sender (100) nach Anspruch 13 aufweist;
wobei jede Bias-Steuerschaltung (800) ein Paar von Stromquellen (814; 824) aufweist, wobei eine Stromquelle konfiguriert ist zum Vorsehen eines ersten Bias-Stroms und die andere Stromquelle konfiguriert ist zum Vorsehen eines zweiten Bias-Stroms, wobei das Bias-Signal, vorgesehen durch die Bias-Steuerschaltung (800) begrenzt ist auf einen Wert zwischen dem ersten und dem zweiten Bias-Strom und ein Paar von Differenzialpaaren (812, 822), und zwar ein Differenzialpaar, gekoppelt an jede Stromquelle (814, 824).

## Revendications

1. Procédé de commande d'un courant de polarisation d'un circuit actif dans un émetteur comprenant une pluralité d'éléments à gain variable et une pluralité de circuits actifs, la commande du courant de polarisation étant basée sur un ou plusieurs signaux de commande de gain pour les éléments à gain variable précédant le circuit actif dans le trajet du signal d'émission, le procédé comprenant :
recevoir au niveau d'un circuit de commande de polarisation les signaux de commande de gain pour lesdits un ou plusieurs éléments à gain variable situés avant le circuit actif dans le trajet du signal d'émission, chaque signal de commande de gain étant indicatif d'une amplitude d'un signal d'entrée sur lequel doit opérer le circuit actif ; et régler le courant de polarisation du circuit actif en accord avec les signaux de commande de gain reçus,
**caractérisé en ce que** un ou plusieurs des signaux de commande de gain reçus peuvent être négligés dans le réglage du courant de polarisation.

2. Procédé selon la revendication 1, dans lequel le circuit actif est situé dans le trajet du signal d'émission.

3. Procédé selon la revendication 1, dans lequel le réglage est effectué par des incréments définis par des incréments de la valeur des signaux de commande de gain reçus.

4. Procédé selon la revendication 3, dans lequel un des signaux de commande de gain reçus est réglé par des incréments comme cela est défini par la norme IS-95-A.

5. Procédé selon la revendication 1, comprenant en outre la limitation du courant de polarisation à une plage définie par un courant de polarisation supérieur et un courant de polarisation inférieur.

6. Procédé selon la revendication 5, dans lequel le courant de polarisation inférieur est réglé entre 0 et 50 % du courant de polarisation supérieur.

7. Procédé selon la revendication 1, dans lequel le courant de polarisation exprimé en fonction des signaux de commande de gain reçus est à peu près conforme à une fonction de transfert en tangente hyperbolique.

8. Procédé selon la revendication 1, dans lequel le courant de polarisation est réglé pour obtenir un niveau de linéarité qui est conforme à une spécification ACPR de réjection de puissance de canal adjacent définie par la norme IS-95-A.

9. Procédé selon la revendication 1, dans lequel le courant de polarisation est compensé en fonction de la température et des variations de l'alimentation.

10. Procédé selon la revendication 1, dans lequel le courant de polarisation est ajusté en fonction de signaux de commande de gain pour tous les éléments à gain variable situés dans le trajet du signal d'émission avant le circuit actif.

11. Procédé selon la revendication 1, comprenant en outre :
la caractérisation d'un niveau de puissance d'entrée du circuit actif en fonction des gains desdits un ou plusieurs éléments à gain variable dans le trajet du signal d'émission ; et
la génération d'une table de valeurs de commande, les valeurs de commande définissant les gains desdits un ou plusieurs éléments à gain variable pour des niveaux de puissance d'entrée spécifiés, les signaux de commande de gain étant produits en accord avec les valeurs de commande provenant de la table.

12. Procédé selon la revendication 1, dans lequel le circuit actif est un trajet de signal d'émission d'un émetteur cellulaire, le courant de polarisation est réglé pour obtenir un niveau de linéarité qui est conforme à une spécification ACPR de réjection de puissance de canal adjacent définie par la norme IS-95-A ; et
le courant de polarisation est limité à une plage définie par un courant de polarisation supérieur et un courant de polarisation inférieur, le courant de polarisation inférieur étant réglé à un pourcentage du courant de polarisation supérieur.

13. Emetteur (100) comprenant :
une pluralité d'éléments à gain variable (126, 146) ;
une pluralité de circuits actifs (144 ; 150) couplés à la pluralité d'éléments à gain variable (126 ; 146), chaque circuit actif recevant un signal d'entrée respectif ayant une amplitude déterminée par un ou plusieurs éléments à gain variable situés avant le circuit actif ;
un circuit de commande de gain (130) couplé à la pluralité d'éléments à gain variable (126 ; 146), le circuit de commande de gain (130) étant agencé pour fournir un signal de commande de gain (128, 148) pour chaque élément à gain variable (126 ; 148) ; et
au moins un circuit de commande de polarisation (160 ; 800) couplé au circuit de commande de gain (130) et à certains sélectionnés de la pluralité des circuits actifs (144 ; 150), le circuit de commande de polarisation (160) étant agencé pour fournir un signal de polarisation pour chaque circuit actif sélectionné (144 ; 150), dans lequel le signal de polarisation pour un circuit actif particulier (144 ; 150) est produit en accord avec lesdits un ou plusieurs signaux de commande de gain (128 ; 148) reçus au niveau du circuit de commande de polarisation pour un ou plusieurs éléments à gain variable (126, 146) situés avant le circuit actif particulier (150), **caractérisé en ce que** un ou plusieurs des signaux de commande de gain reçus peuvent être négligés dans la génération du signal de polarisation.

14. Emetteur (100) selon la revendication 13, dans lequel chaque élément à gain variable (126 ; 146) est mis en oeuvre avec un amplificateur à gain variable (VGA), un atténuateur ou un multiplieur.

15. Emetteur (100) selon la revendication 13, dans lequel la pluralité de circuits actifs comprend un mélangeur (144).

16. Emetteur (100) selon la revendication 13, dans lequel la pluralité de circuits actifs comprend un amplificateur de puissance (150).

17. Emetteur (100) selon la revendication 13, dans lequel chaque circuit de commande de polarisation (800) comprend une paire de sources de courant (814 ; 824), une première source de courant étant agencée pour fournir un premier courant de polarisation et l'autre source de courant étant agencée pour fournir un deuxième courant de polarisation, dans lequel le signal de polarisation fourni par le circuit de commande de polarisation (800) est limité à une valeur comprise entre les premier et deuxième courants de polarisation.

18. Emetteur (100) selon la revendication 17, dans lequel chaque circuit de commande de polarisation (800) comprend en outre deux paires différentielles (812 ; 822), une paire différentielle étant couplée à chaque source de courant (814 ; 824) .

19. Emetteur (100) selon la revendication 17, dans lequel les sources de courant (814 ; 824) sont programmables.

20. Emetteur (100) selon la revendication 13, comprenant en outre une source de référence à intervalle de bande couplée audit au moins un circuit de commande de polarisation (800).

21. Emetteur (100) selon la revendication 13, dans lequel la pluralité d'éléments à gain variable (126 ; 146) et la pluralité de circuits actifs (144 ; 150) sont mises en oeuvre dans un circuit intégré monolithique.

22. Emetteur (100) selon la revendication 13, dans lequel la pluralité d'éléments à gain variable (126 ; 146) et la pluralité de circuits actifs (144 ; 150) sont mises en oeuvre en utilisant des éléments discrets.

23. Téléphone cellulaire comprenant l'émetteur (100) selon la revendication 13, dans lequel chaque circuit de commande de polarisation (800) comprend deux sources de courant (814 ; 824), une source de courant étant agencée pour fournir un premier courant de polarisation et l'autre source de courant étant agencée pour fournir un deuxième courant de polarisation, dans lequel le signal de polarisation fourni par le circuit de commande de polarisation (800) est limité à une valeur comprise entre les premier et deuxième courants de polarisation, et deux paires différentielles (812 ; 822), une paire différentielle étant couplée à chaque source de courant (814 ; 824).
